Europäisches Patentamt

European Patent Office

Office européen des brevets

(19)

(11) Publication number : **0 350 833 B1**

# EUROPEAN PATENT SPECIFICATION

(12)

(45) Date of publication of patent specification :
04.10.95 Bulletin 95/40

(51) Int. Cl.⁶ : **H01L 23/495, H01L 25/16**

(21) Application number : **89112574.2**

(22) Date of filing : **10.07.89**

(54) **Integrated circuit package structure.**

(30) Priority : **11.07.88 JP 172433/88**
**10.01.89 JP 3318/89**
**19.01.89 JP 12605/89**
**09.05.89 JP 117126/89**

(43) Date of publication of application :
**17.01.90 Bulletin 90/03**

(45) Publication of the grant of the patent :
**04.10.95 Bulletin 95/40**

(84) Designated Contracting States :
**DE FR GB IT**

(56) References cited :
**EP-A- 0 180 219**
**EP-A- 0 261 324**
**US-A- 4 797 726**
**PATENT ABSTRACTS OF JAPAN, vol. 13, no.**
**301 (E-785), 11 July 1989 ; & JP-A-01 080 051**
**PATENT ABSTRACTS OF JAPAN, vol. 1, no.**
**153 (E-072), 8 December 1977 ; & JP-A-52 095**
**173**
**PATENT ABSTRACTS OF JAPAN, vol. 8, no. 99**
**(E-243), 10 May 1984 ; & JP-A-59 016 357**
**PATENT ABSTRACTS OF JAPAN, vol. 11, no.**
**363 (E-560), 26 November 1987 ; & JP-A-62 137**
**859**
**PATENT ABSTRACTS OF JAPAN, vol. 13, no.**
**307 (E-787), 13 July 1989 ; & JP-A-01 082 554**
**PATENT ABSTRACTS OF JAPAN, vol. 13, no.**
**106 (E-726), 14 March 1989 ; & JP-A-63 278 360**

(56) References cited :
**PATENT ABSTRACTS OF JAPAN, vol. 7, no.**
**255 (E-210)(1400), 12 November 1983 ; & JP-**
**A-58 140 141**
**PATENT ABSTRACTS OF JAPAN, vol. 11, no.**
**104 (E-494), 2 April 1987 ; & JP-A-61 253 840**
**PATENT ABSTRACTS OF JAPAN, vol. 5, no. 44**
**(E-050), 24 March 1981 ; & JP-A-55 165 654**

(73) Proprietor : **FUJITSU LIMITED**
**1015, Kamikodanaka,**
**Nakahara-ku**
**Kawasaki-shi, Kanagawa 211 (JP)**

(72) Inventor : **Matsuzaki, Toshio c/o FUJITSU**
**LIMITED**
**Patent Department**
**1015 Kamikodanaka**
**Nakahara-ku Kawasaki-shi Kanagawa 211**
**(JP)**
Inventor : **Toshima, Hiroaki c/o FUJITSU**
**LIMITED**
**Patent Department**
**1015 Kamikodanaka**
**Nakahara-ku Kawasaki-shi Kanagawa 211**
**(JP)**

(74) Representative : **Sunderland, James Harry et**
**al**
**HASELTINE LAKE & CO**
**Hazlitt House**
**28 Southampton Buildings**
**Chancery Lane**
**London WC2A 1AT (GB)**

EP 0 350 833 B1

## Description

The present invention relates to integrated circuits and more particularly to package structures for integrated circuits, including hybrid integrated circuits in which active and passive elements are incorporated.

For package structures for semiconductor integrated circuits or hybrid integrated circuits, epoxy resin is very popular and widely used as a molding material, and an insert-mold method is utilised which lends itself to mass production. A circuit substrate and a lead frame are incorporated in molding material during the mold process.

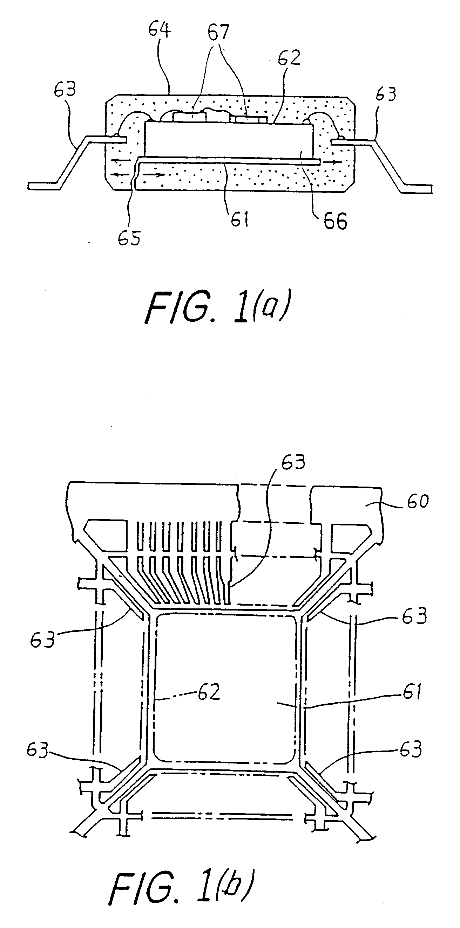

Figs. 1(a) and 1(b) show respectively a schematic cross-sectional view of a conventional hybrid integrated circuit and a plan view of a lead frame used therein.

The lead frame 60 has a square support plate 61 centrally arranged, which plate is sometimes called a stage or tab. On the support plate 61 a circuit substrate 62 is mounted and is selectively connected to leads 63 by a wire bonding method. The above structure is finally molded as a package 64 of epoxy resin material. The circuit substrate 62 comprises a base member 66, for example of alumina ceramic, epoxy glass or silicon, and active and passive elements 67 disposed on the base member 66.

In the package structure such as disclosed above, differences in expansion coefficients, adhesion characteristics, etc., between the various constituent parts comprised therein can cause a problem of cracking of the mold package.

Usually, the expansion coefficient of the base member 66 is smaller than that of the molding material, and adhesive strength between the mold material and the support plate 61 (e.g. a metal plate) is less than that between the mold material and the base member 66. When the device (hybrid integrated circuits or integrated circuits are sometimes called devices, for brevity, in the present application) is put into operation and is subjected to repeated heat cycles of expansion and contraction, the lower portion of the mold package 64 may not withstand the stress induced, which is concentrated along a periphery of the support plate 61, and finally the mold package 64 of the device may manifest a crack 65 along a side or along two neighbouring sides of the square periphery of the support plate, as shown in Fig. 1(a).

In order to relieve stress at the support plate, arising due to its different expansion characteristics as compared with the mold material, an idea of forming a lead frame which has an opening or a void portion in the support plate was disclosed in the Japanese Unexamined Patent Publication JP-52-95173 dated 10th August 1977 by S. Kobayashi. The patent discloses that the support plate of the lead frame is composed of a surrounding peripheral frame portion with either a single or a plurality of openings formed therein.

Another idea was disclosed in Japanese Unexamined Patent Publication JP-63-81966 dated 12th April 1988 by H. Tsutani, et al. The patent discloses that the device comprises a lead frame, a support plate thereof having a plurality of cuts extending from its periphery towards the centre of the support plate.

The two disclosures mentioned above are concerned each with a semiconductor integrated circuit which comprises a single monolithic semiconductor chip mounted on the support plate. Generally, the semiconductor chip size (surface area) is comparatively small compared with the outline dimensions of the mold package.

Patent Abstracts of Japan 8(099),(E-243) (Publication NO. 59-016357) discloses a lead frame with holes. The holes are filed with mold resin when the lead frame, with a pellet mounted thereon, is resin sealed. This constitution is said to provide a package which is strong with regard to thermal stress and moisture, etc..

With the trend towards higher integration, a hybrid integrated circuit, which comprises a circuit substrate and a plurality of active and passive elements mounted thereon, has come to be larger in size, so that the circuit substrate occupies a substantial part of the molding size. In these circumstances, the stress generated in the mold package during operation becomes a serious problem.

According to the present invention there is provided an integrated circuit, comprising:-

a circuit substrate, comprising a base member and at least one semiconductor element, an active element or a passive element, disposed on the base member,

a lead frame comprising at least a plurality of leads and a support plate, respectively provided at outward and inward portions of the lead frame, and each lead having an inner lead portion and an outer lead portion,

the circuit substrate being disposed on the support plate and selectively electrically, connected with inner ends of inner lead portions,

a mold of resin material packaging the circuit substrate, support plate and inner lead portions, the ratio of the surface area of the base member to the principal surface area of the mold package being greater than 60%, and

the support plate having an opening for exposing the bottom surface of the base member to the mold, the ratio of the exposed bottom surface area to the entire bottom surface area thereof being greater than 50%, and wherein

the support plate comprises four stages arranged at respective corners of either an imaginary square shape or an imaginary rectangular shape, the stages being spaced apart and supporting the base member, and the bottom surface area of the base member being not larger than that of the imaginary square or rectangular shape.

An embodiment of the present invention can provide a hybrid integrated circuit which is more resistant to the effects of repeated heat cycles of expansion and contraction.

An embodiment of the present invention can provide a package structure of a hybrid integrated circuit, which affords excellent durability even when hybrid integrated circuit is constructed with a notably large scale of integration.

An embodiment of the present invention can provide a hybrid integrated circuit which can be fabricated by methods similar to those conventionally used.

An embodiment of the invention can provide a package structure of a hybrid integrated circuit such that reduced or minimum deformation of the mold package occurs between premolding and postmolding states.

Embodiments of the present invention can provide hybrid integrated circuits which are more resistant to the effects of repeated cycles of thermal expansion and contraction.

By applying the above structure of a hybrid integrated circuit, the molding material of epoxy resin contacts the bottom surface of the circuit substrate with a stronger adhesive force than in a case in which mold material contacts the support plate directly, as in the prior art mentioned above. Further, because the support plate area is reduced as compared with the case in which no opening is provided, stress due to thermal expansion of the support plate is also reduced and is further distributed over the entire surface thereof. These factors combine in effect to provide for the avoidance of or the reduction of rate of occurrence of package crack defects.

In an embodiment of the present invention, in order to minimise or reduce change of characteristics of active or passive elements comprised in a hybrid or non-hybrid integrated circuit between premolding and postmolding states, the relationship between mold thickness above and below the circuit substrate may be selectively chosen, in dependence upon the relationship between expansion coefficients of the circuit substrate and the support plate.

Normally, during a molding process for forming a package, a preassembled hybrid, for example, integrated circuit is heated up to about 175°C which causes a deformation thereof. The deformation remains after the molding process, which is the cause of the characteristic change. The deformation can be reduced or eliminated with a package structure in accordance with an embodiment of the present invention.

According to an embodiment of the present invention it is provided that:-

mold thickness above the base member is smaller than that below the base member when the thermal expansion coefficient of the circuit substrate is smaller than that of the support plate, or

mold thickness above the base member is larger than that below the base member when the thermal expansion coefficient of the circuit substrate is larger than that of the support plate.

Reference is made, by way of example, to the accompanying drawings, in which:-

Fig. 1(a) is a schematic cross-sectional view of a conventional hybrid integrated circuit, and Fig. 1(b) is a plan view of a lead frame used in the device shown in Fig. 1(a), a support plate thereof having no opening,

Fig. 2 is a schematic cross-sectional view of a hybrid integrated circuit for assistance in explaining the present invention,

Fig. 3 is a plan view of a lead frame used in Fig. 2, the lead frame having an opening in a support plate,

Fig. 4(a) is a graph illustrating relationship between percentage occupancy and tendency for crack occurrence, where percentage occupancy is given by a ratio of the surface area ($S_0$) of a circuit substrate to that ($S_1$) of a mold package, and

Fig. 4(b) is a schematic top view of a device with a package, partly cut away, in which $S_0$ and $S_1$ are indicated,

Fig. 5 is a graph of test result data for several embodiments of the present invention, illustrating relationship between crack occurrence percentage and number of heat cycles, for various surface area ratio percentages,

Figs. 6(a) to 6(i) are respective top or plan views illustrating various configurations of support plate comprised in lead frames in embodiments of the present invention, the support plate having a variety of opening shapes therein, and

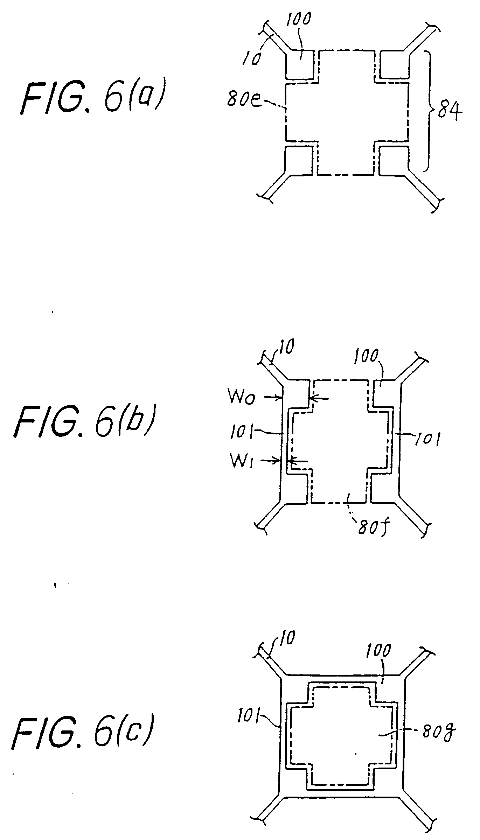

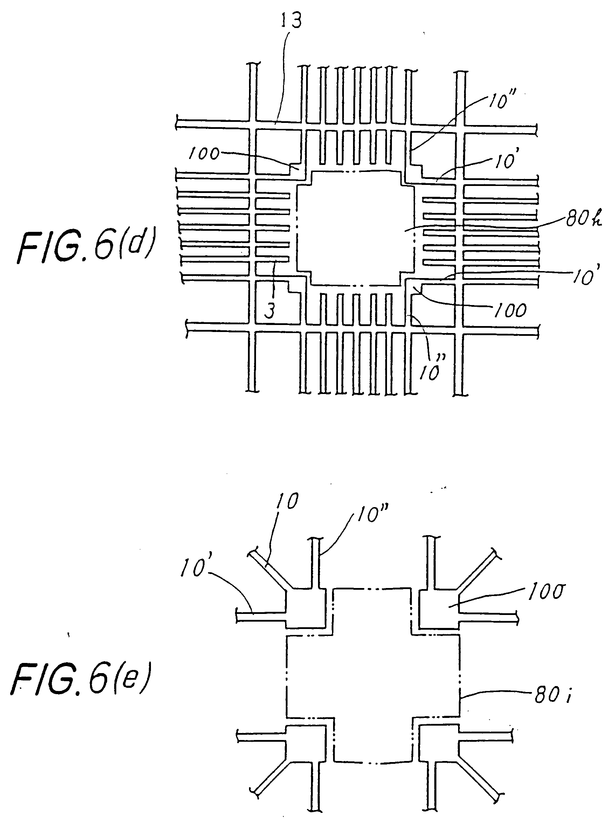

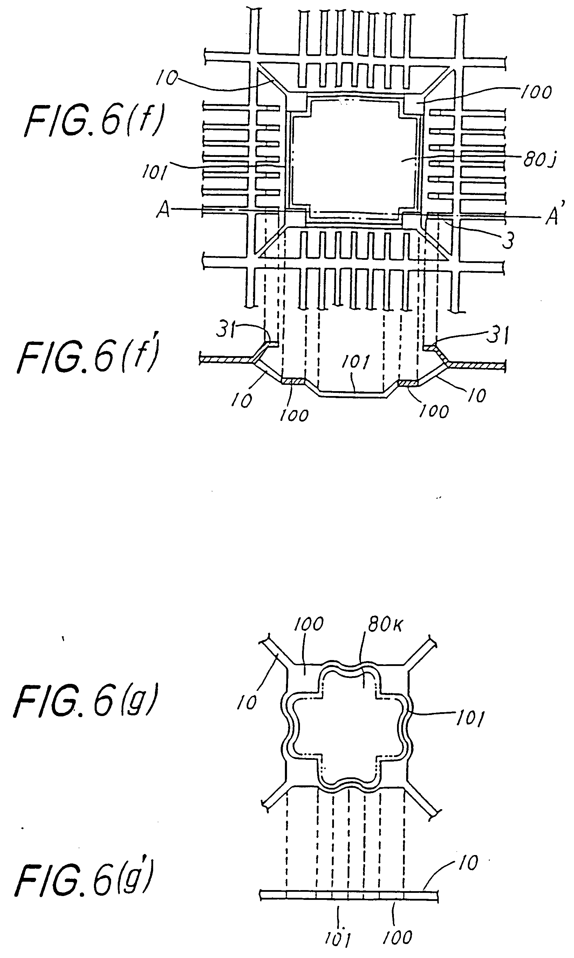

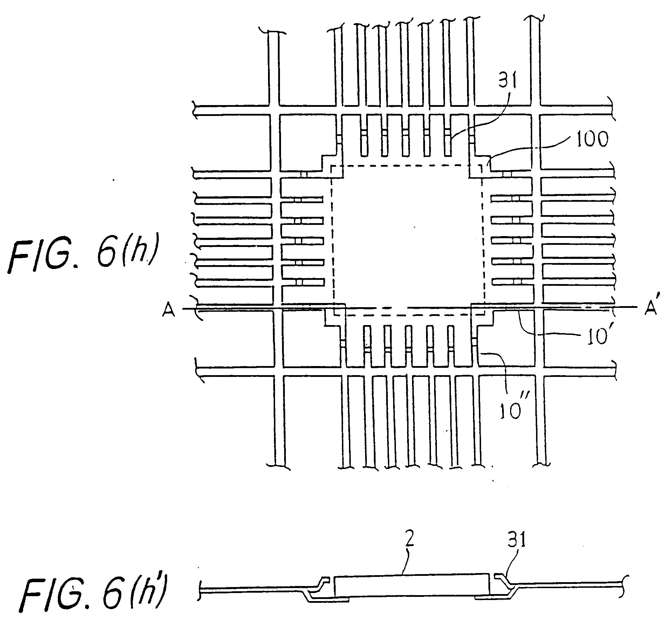

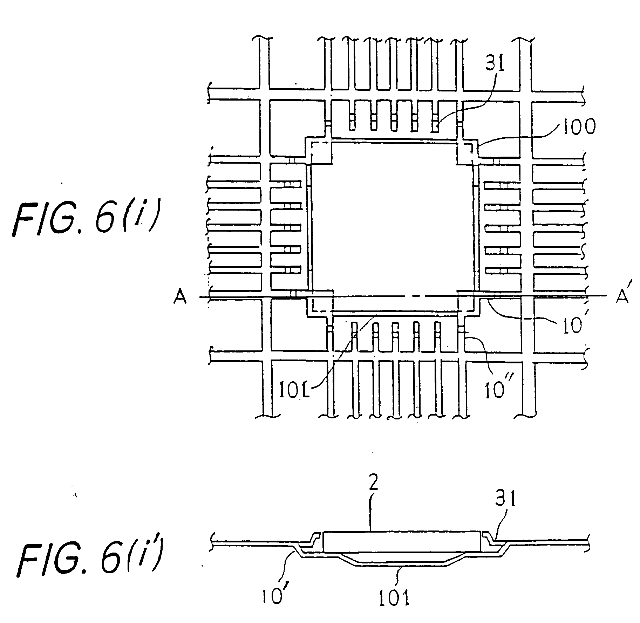

Figs. 6(f′) to 6(i′) are respective cross-sectional views of lead frames, some including circuit substrates, of Figs. 6(f) to 6(i) respectively,

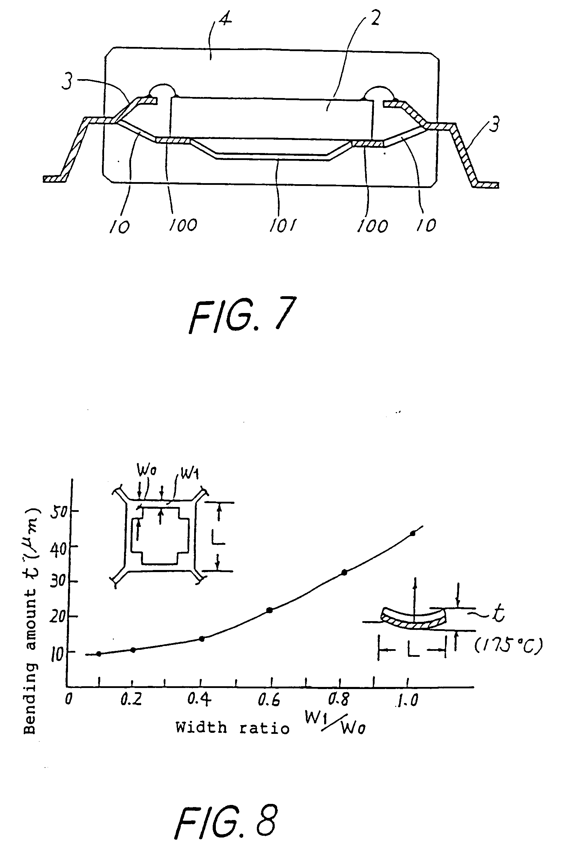

Fig. 7 is a schematic cross-sectional view of a device in accordance with an embodiment of the present invention, with a mold package, when the lead frame of Fig. 6(f′) is used,

Fig. 8 is a graph illustrating a relationship between a bending amount and width ratio between a connecting bar and a support plate stage when a lead frame as seen in Fig. 6(c) is utilised,

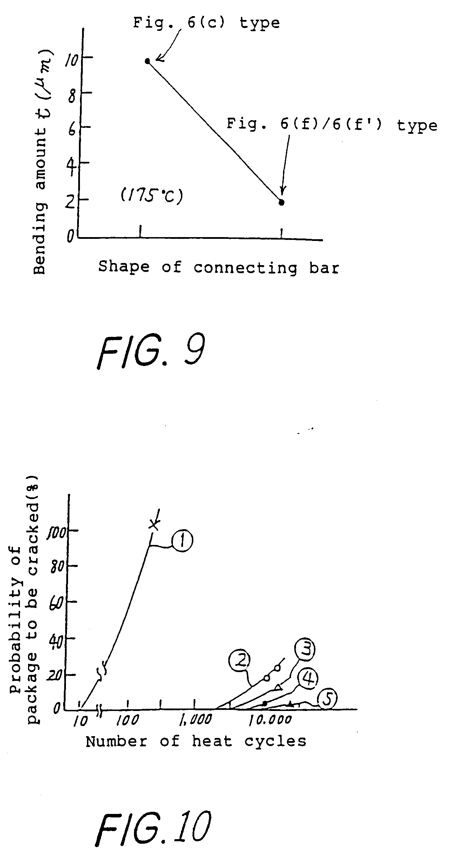

Fig. 9 is a diagram illustrating a relationship between a bending amount and configuration or shape of connecting bar when lead frames of Figs. 6(c) and 6(f)/6(f') types are utilised,

Fig. 10 is a graph of test results illustrating relationships between crack occurrence percentage and number of heat cycles for various configurations of support plate,

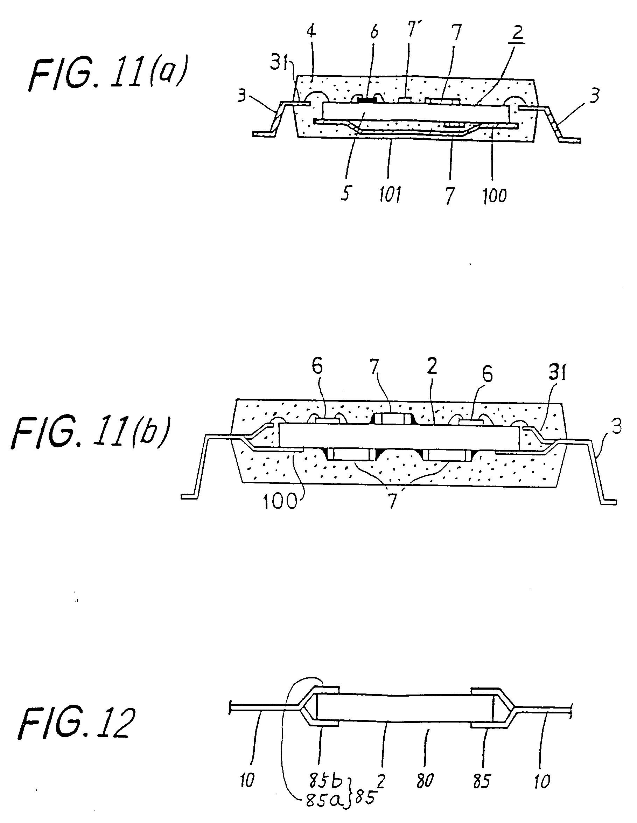

Figs. 11(a) and 11(b) are respective schematic cross-sectional views of hybrid devices in accordance with embodiments of the present invention molded in packages using lead frames of Figs. 6(f)/6(f') and 6(h)/6(h') types,

Fig. 12 is a cross-sectional view of a clipping or pinching structure of support plate for embodiments of the present invention, where a circuit substrate is clipped or pinched by a pair of clippers or pincers,

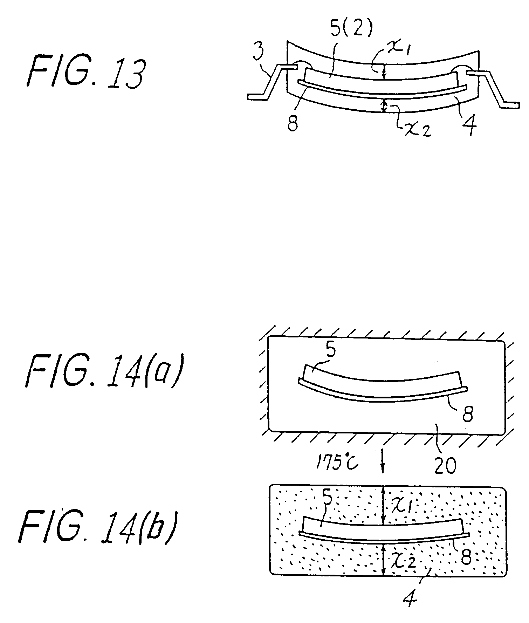

Fig. 13 is a schematic cross-sectional view of a device illustrating deformation caused by a difference in expansion characteristics between circuit substrate and support plate,

Figs. 14(a) and 14(b) illustrate schematically two sequential steps in which the mold package is deformed when $x_1$ and $x_2$ are almost equal,

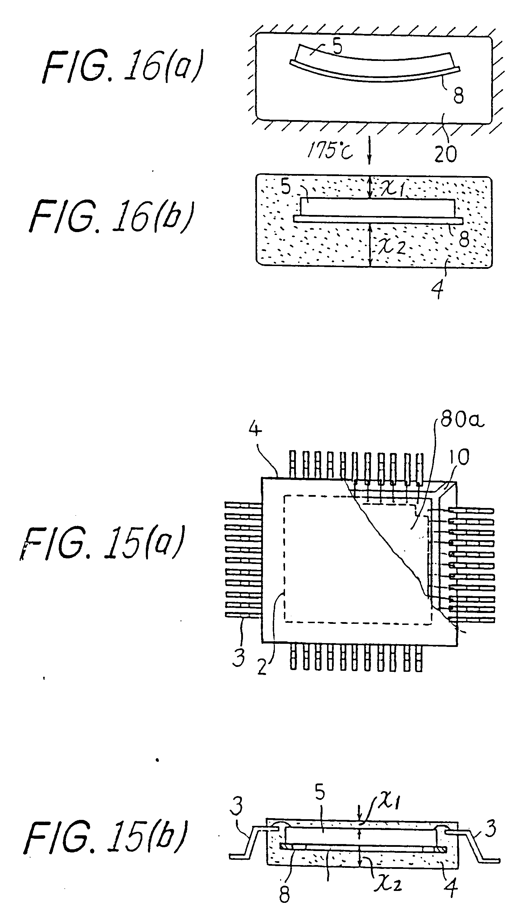

Figs. 15(a) and 15(b) are a top view, partly cut away, and a cross-sectional view, of the device according to the present invention for explaining a device structure by which deformation of the mold package is eliminated or reduced,

Figs. 16(a) and 16(b) are illustrations similar to those at Figs. 14(a) and 14(b) when a structure in accordance with the present invention is applied in order to eliminate deformation, and

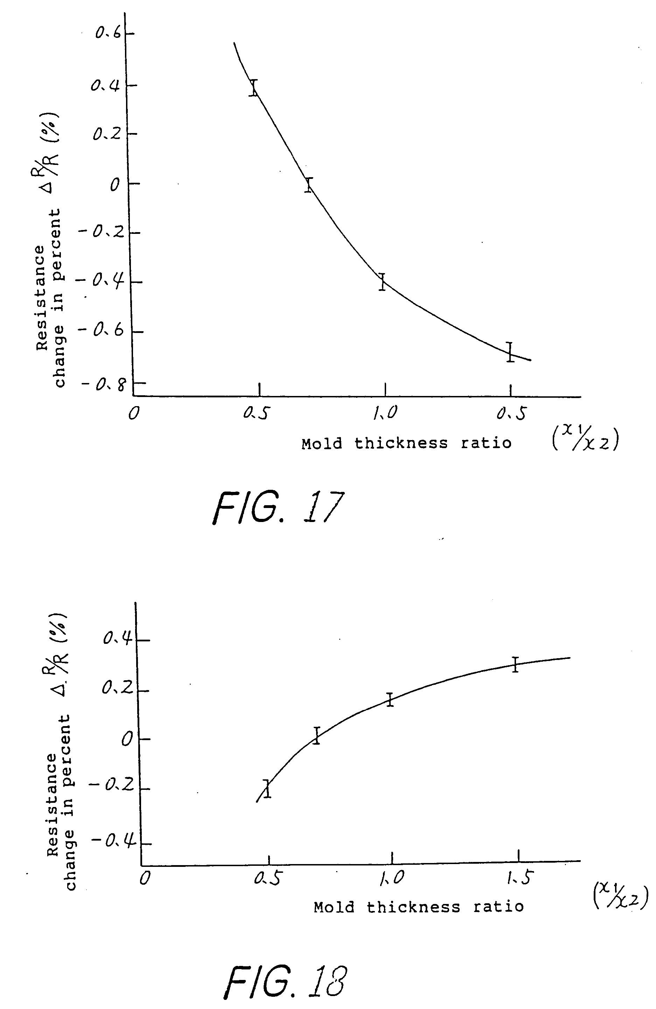

Figs. 17 and 18 are graphs, each illustrating a relationship between a resistance change, for upper and lower resistors respectively, and a thickness ratio $x_1/x_2$, which indicate an optimum value of $x_1/x_2$ for which deformation is eliminated or minimised, wherein upper and lower resistors are formed respectively on front (upper) and bottom (lower) surfaces of a circuit substrate, and $x_1$ and $x_2$ denote thicknesses of a mold package above and below the circuit substrate respectively.

Throughout the drawings, the same reference signs designate the same or similar parts.

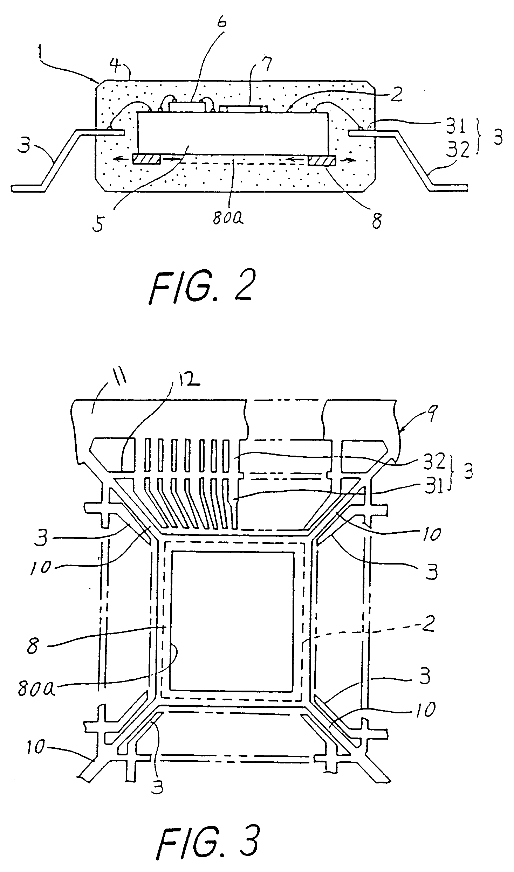

A hybrid integrated circuit for assistance in explaining the present invention is shown in cross-section in Fig. 2, and Fig. 3 is a top view of a lead frame 9 used in Fig. 2.

The lead frame 9 is made of any of copper alloy, iron nickel alloy, etc. A circuit substrate 2 comprises a base member 5 and chip parts (6, 7) mounted and fixed thereon. The base member 5 is of insulating material such as alumina ceramic, epoxy glass, glass coated metal, oxide covered silicon, sapphire, etc. The chip parts may include any active and/or passive elements, such as a semiconductor active element 6 forming an integrated circuit, a capacitor chip 7, etc. These chip parts are bonded on the base member 5 by conductive bonding resin and terminals thereof are selectively connected to bonding pads on the base member 5 and/or are mutually interconnected. The circuit substrate 2 is mounted on a support plate 8 and is fixed thereon by heat resistive adhesive. A plurality of leads 3 of the lead frame 9 are arranged on each side of the circuit substrate 2, and a lead 3 is composed of an inner lead 31 and outer lead 32. An inside end of an inner lead 31 is connected selectively to a bonding pad on the base member 5. The whole structure, except for substantial portions of the leads 3, is molded in a mold package 4 of epoxy resin, forming a completed hybrid integrated circuit 1.

Chip parts 6, 7 are mentioned as illustrations of possible active and passive elements. However, such elements used in embodiments of the invention are not restricted to chip parts. For instance, they may be thick or thin film parts (not shown in Fig. 2), forming capacitors or resistors, which are directly formed on the base member 5 by screen printing or sputtering methods.

The leads 3 and support plate 8 are integral parts of the lead frame 9, and the support plate 8 has an outline of a square shape having a square opening 80a therein. Therefore, the support plate 8 has four side strips forming a square outline, and is connected to the remainder of the lead frame by support bars 10. The opening 80a is formed with a predetermined size such that the remaining four side strips of the support plate 8 are of sufficient size to support the base member 5, it being preferable that the base member 5 does not extend beyond the outermost outline edges of the support plate. Dimensions of the base member 5 are indicated by broken lines 2 in Fig. 3. The support plate 8 is centrally located in the lead frame 9, and inside ends of inner leads 31 are disposed close to the support plate 8 for easy connection, by a wire bonding process, to bonding pads on the circuit substrate 2. An outside frame portion 11 and an interconnection bar 12 between leads 3 are removed after the molding process.

The opening 80a functions to make or allow resin material flow freely to the bottom surface of the circuit substrate 2 (base member 5) and adhere thereto during a molding process of the mold package 4, utilising a transfer-mold method.

## TABLE 1

| Part Name (Material) | Adhesive Strength against Shearing Force $(kg/mm^2)$ |
|---|---|
| Lead frame (copper alloy) | 0.2 |
| Semiconductor chip (silicon) | 5.0 |
| Base member (alumina) | 6.0 |
| Base member (epoxy glass) | 2.0 |

Adhesive strengths against shearing force of bonds between epoxy resin of the mold package 4 and other parts such as base member 5 and support plate 8 comprised therein are shown in TABLE 1.

The functions of the opening 80a formed in the support plate 8 will next be explained.

When the device 1 is heated up, the mold package 4, circuit substrate 2, support plate 8, etc., suffer different amounts of expansion. The mold material of package 4 directly contacts the base member 5 through the opening 80a (of predetermined size) and therefore, in this case (as seen from TABLE 1) the adhesive strength of the adhesion of the mold package 4 to the base member 5 is much greater than the adhesive strength achieved in a case in which a support plate without an opening is used, as in previous proposals. The lower portion of the package 4 under the base member 5 is fixed more rigidly thereto, and cannot easily move apart from the bottom surface of the base member 5.

Further, because the effective area of the support plate 8 is remarkably reduced, stress due to expansion of the support plate is also reduced and further distributed to the overall fringe portions thereof, resulting in avoidance of stress concentration at the outer fringe portion only. The above two factors contribute to eliminate or reduce the chances of the package 4 cracking.

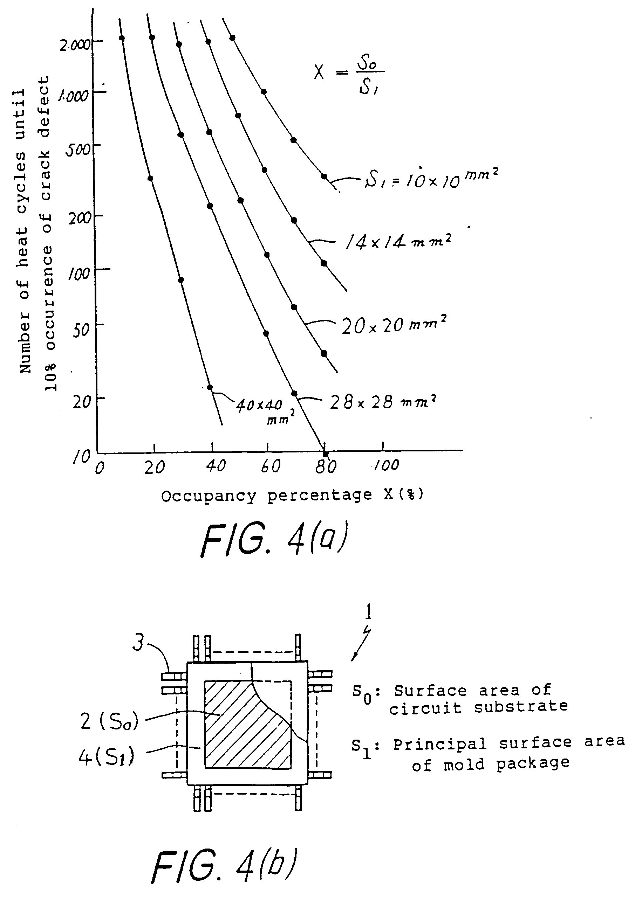

Crack occurrence probability increases significantly as package size becomes larger when a support plate without an opening is utilised. Fig. 4(a) is a graph illustrating data indicating the relationships between percentage occupancy X of the circuit substrate 2 and tendency to crack occurrence for different package sizes (for support plates without openings). Percentage occupancy is indicated along the abscissa and is defined by the ratio of surface area $S_0$ of the circuit substrate 2 (base member 5) to principal surface area $S_1$ of the mold package. Tendency to crack occurrence is indicated along the ordinate and is defined by the number of heat cycles needed until a 10% rate of occurrence of crack defects is observed among test pieces. The percentage occupancy X is, therefore, expressed by a ratio $S_0/S_1$, $S_0$ defining the surface area of circuit substrate 2 and $S_1$ defining the principal surface area of mold package as shown in Fig. 4(b).

In order to perform the above tests, a large number of circuit substrates having a square shape and a thickness of 0.5 mm but having different percentage occupancies were prepared in each of five groups having respective different mold package sizes. Further, a large number of lead frames, having different sizes of support plate of a square shape without an opening, were prepared corresponding to each of the five package size groups. The percentage occupancy becomes 80% when the surface areas of the support plate and circuit substrate are equal.

To fabricate the test pieces, each of the circuit substrates was mounted on the square support plate of a lead frame and fixed thereto by adhesive. Each test piece, having a 4 mm thickness of the mold package 4 and as shown in Fig. 4(b), is obtained after molding in epoxy resin by a transfer-mold method. Different package outline dimensions were fabricated by changing the dimensions of the molding die. In this way, test pieces in five different package size groups were provided, each group including different percentage occupancies.

Test piece were subjected to a heat cycle test which included the steps of dipping in a solution at -55°C for five minutes and dipping in a solution at 125°C for five minutes. The number of heat cycles needed to reach a state in which 10% of test pieces manifested a package crack was measured for each package size and occupancy percentage. The results are shown in Fig. 4(a).

In Fig. 4(a), X denotes the ratio of surface area $S_0$ of the circuit substrate to principal surface area $S_1$ of the package. It can be seen from the Figure that, when either the package size becomes larger or the percentage occupancy X becomes larger, the package is more liable to be cracked. Liability to cracking is more seriously pronounced as package size grows larger. When X is larger than 60%, a package of the smallest size, 10 x 10 $mm^2$, cannot withstand 1000 heat cycles, which is the criteria used for judging whether or not a package can be employed in practice.

5

This is a serious problem for hybrid integrated circuits having circuit substrates of large size and a high occupancy percentage X. Generally, a semiconductor integrated circuit including a single semiconductor chip has at most a surface area of about 15 x 15 mm$^2$, and the occupancy percentage X (ratio of area of the semiconductor chip to the package outline) is less than 50%, mostly less than 30%. Under these conditions the semiconductor chip is completely covered by epoxy resin and buried in the package, and there is very little chance of a package crack occurring. Therefore, package cracking has almost been left out of consideration. When the occupancy percentage X is increased over 60%, the thickness of the package becomes comparatively small and the mold package becomes very susceptible to cracks. When the package size is further increased above 20 x 20 mm$^2$, resistance to cracking is further decreased, and finally it becomes almost impossible to obtain usable devices by using the square support plate without opening.

A hybrid integrated circuit in accordance with an embodiment of the present invention enables the application of an occupancy percentage X of the circuit substrate in a range greater than 60% without significant package cracking, with the result that package size can be made smaller and integration density increased.

According to the present invention, a support plate having an opening is utilised. For assistance in explanation, reference is made to Figs. 2 and 3 where opening 80a, allowing resin material to flow to the bottom surface of the circuit substrate 2 is formed in the support plate 8.

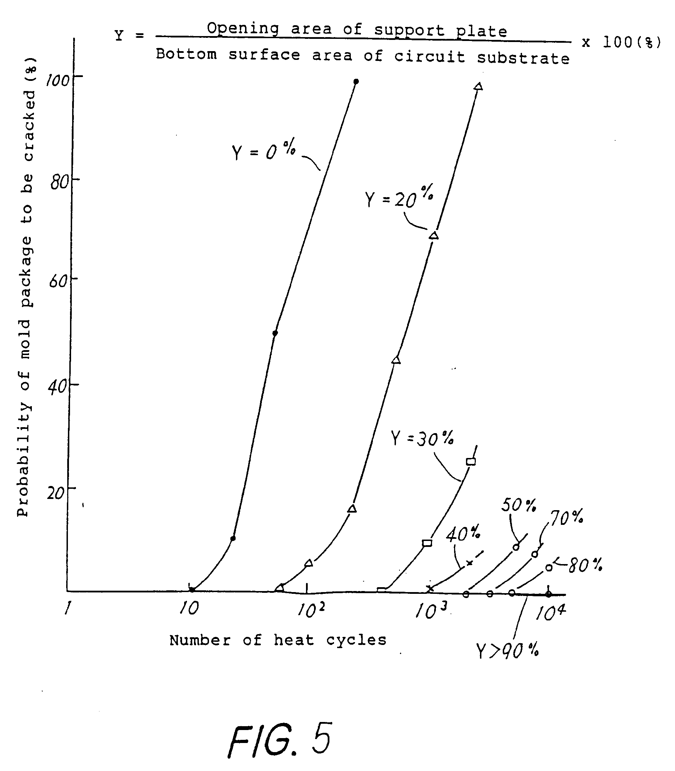

Fig. 5 is a graph illustrating heat cycling test results when the tests were carried out on hybrid integrated circuits provided with openings 80a in their support plates. The circuits were subjected to alternate dipping steps into solutions at -55°C and 125°C for five minutes each. For the hybrid integrated circuits used for the tests, lead frames of copper alloy were employed, and the circuit substrates had a surface area of 28 x 28 mm$^2$ and the percentage occupancy X thereof to the mold package was about 67%.

An area ratio Y in percent is defined by the following equation,

$$Y = \frac{\text{Opening area of support plate}}{\text{Bottom surface area of circuit substrate}} \times 100(\%).$$

If the outside peripheral shape, in the case of Fig. 5 a square, of the support plate having the opening is not the same as that of the circuit substrate, the numerator of the above equation is preferably modified to a more precise expression such as "the exposed bottom area of the circuit substrate, directly contacting the mold package". When both outside dimensions of the support plate and substrate circuit are the same or become large, the two definitions are the same or indicate almost the same area.

The test results are illustrated in Fig. 5 and the curves therein indicate the probability of a mold package being cracked versus the number of heat cycles applied thereto. As the area ratio Y becomes larger, the curve moves toward the right and lower region in Fig. 5, which means the crack occurrence probability decreases. Each curve pertaining to a specific value of Y was obtained using 50 test pieces. The test results make clear that crack occurrence can be controlled by providing the opening 80a in the support plate 8.

Even when Y is made greater than 50%, the mold package can withstand over 1000 heat cycles, and there is therefore no problem in conventional practical use. Further, when area ratio Y is made larger than 80%, preferably 90%, hybrid integrated circuits can be obtained exhibiting virtually no package cracking problems.

In Figs. 2 and 3, an opening of a square shape is formed in the support plate. However, the shape of the opening need not be restricted to a square shape. A rectangular shape may be used, for instance when the circuit substrate is rectangular. The shape may be changed depending on the design of the circuit substrate.

Fig. 6(a) illustrates a first embodiment of the present invention. The Figure shows only a partial plan view of a lead frame omitting outer lead and frame portions thereof, because the omitted portions of the lead frame are substantially the same as those in Fig. 3. Four square stages 100 form the support plate, the stages being provided at respective corners of an assumed square shape having a side length 84. Each stage 100 is supported and connected to the remainder of the lead frame by a single support bar 10 extending in an outward diagonal direction. Chain lines 80e denote schematically the opening of the support plate 8, which is substantially the same as the exposed bottom surface area of the circuit substrate 2. Similar chain lines and similar reference numerals to 80e are used in following Figures.

A stage 100 need not be restricted to square shape, but may be rectangular or circular in shape. Further, the number of stages may be increased depending on a size of the circuit substrate 2.

Figs. 6(b) and 6(c) illustrate second and third embodiments of the present invention.

In Fig. 6(b), pairs of stages 100 are connected by connecting bars 101, and in Fig. 6(c), all four stages are connected by four connecting bars 101.

In both Figures, connecting bars 101 have a width $W_1$ less than that $W_0$ of a stage 100. In support plates with these structures effective stabilisation of stage positions one to the other, when the circuit substrate 2 becomes large, is afforded.

Figs. 6(d) and 6(e) illustrate fourth and fifth embodiments of the present invention, which are further modifications of the embodiment of Fig. 6(a). In Fig. 6(d), each stage 100 is supported by two support bars 10'

and 10″. In Fig. 6(e), each stage 100 is supported by three support bars 10, 10′ and 10″. when the support bar structure for a stage is composed of a single support bar, such as is shown in Fig. 6(a), mechanical strength is sometimes insufficient. For example, when the circuit substrate 2 is bonded on stage 100, the stage is easily subjected to deformation or a position shift, resulting in inferior quality in wire-bonding and in other respects.

On the other hand, the structures shown in Figs. 6(d) or 6(e) increase the support strength of stages 100 by increasing the number of support bars to two or three.

TABLE 2 shows measured displacements of a stage 100 after bonding a circuit substrate 2 thereon, for two different support bar structures as shown in Figs. 6(a) and 6(d) respectively. The displacements were measured in each of X-, Y- and Z-directions. Test pieces for these measurements had structures such that stages 100 were located substantially on each corner of a square 24 x 24 mm², i.e. the side length 84 of Fig. 6(a) was about 24 mm, and a stage 100 formed a square of 3 x 3 mm². The width of support bars 10, 10′ and 10″ of Fig. 6(d) was about 0.65 mm, and the length of support bars 10 of Fig. 6(a) was about 12 mm and the length of support bars 10′, 10″ to a connecting bar 13 in Fig. 6(d) was about 8.5 mm. The base members forming the circuit substrates had a size of 23 x 23 mm² and were made of alumina ceramic having a 0.5 mm thickness, and bonded on the stages by heat resistive silicon resin. TABLE 2 shows average data for 50 test pieces for both types, measured by a dial gauge and a microscope.

## TABLE 2

| Type of Support Plate | Displacement | | |
|---|---|---|---|
| | X-direction | Y-direction | Z-direction |
| Fig. 6(a) type | 0.55 mm | 0.35 mm | 0.1 mm |
| Fig. 6(d) type | 0.04 mm | 0.04 mm | 0.05 mm |

As seen in TABLE 2, the displacement decreases by a factor of about ten by changing the number of support bars from one to two. In Fig. 6(d), two support bars 10′ and 10″ are used for a stage, the directions thereof forming a right angle and being parallel to sides of the stage. By increasing the number of support bars to three as shown in Fig. 6(e), further improvement can be expected for molding a larger size of circuit substrate. In Fig. 6(e), two support bars 10′ and 10″ form a right angle, each direction being parallel to a side of a square shape, and the remaining support bar 10 is arranged in an outward diagonal direction.

Figs. 6(f) and 6(f′) illustrate a sixth embodiment of the present invention, in which Fig. 6(f) shows a partial plan view of a lead frame and Fig. 6(f′) shows a cross-section along the line A-A′ in Fig. 6(f). The plan view is very similar to that of Fig. 6(c), but, as shown in Fig. 6(f′), a stage 100 is displaced to a lower position from an original frame level. On the other hand, the inside ends of inner leads 31 are bent upwardly to an upper position in order to bring bonding positions of inner leads and the circuit substrate to the same level even when a thick circuit substrate is utilised. In Fig. 6(f′), a connecting bar 101 has two further sloped portions and a horizontal portion, which contribute to relieve stress.

Fig. 7 shows a schematic cross-section of a hybrid integrated circuit when a circuit substrate is mounted on this type of the lead frame (of Fig. 6(f)) having upwardly deformed inner leads and lowered stages and is molded in a package.

Figs. 6(g) and 6(g′) illustrate a seventh embodiment of the present invention, in which Fig. 6(g) is a plan view of the support plate and Fig. 6(g′) is a cross-sectional view thereof. A connecting bar 101 has an undulation in the same plane as the stages 100. The undulation makes the support plate more flexible and has an effect of relieving stress between the circuit substrate 2 and the support plate.

Figs. 6(h) and 6(h′) illustrate an eighth embodiment of the present invention which is a modification of that of Fig. 6(d). The top or plan view of Fig. 6(h) is quite similar to that of Fig. 6(d). However, as seen from Fig. 6(h′), which is a cross-sectional view taken along line A-A′ of Fig. 6(h), stages 100 are lowered and inner leads 31 are bent upwardly, with the result that the inside ends of the inner leads 31 are maintained at the same level as the surface of circuit substrate 2.

Figs. 6(i) and 6(i′) illustrate a ninth embodiment of the present invention, which is a modification of the embodiments of Fig. 6(c) or Fig. 6(d). Stages 100 are mutually interconnected by connecting bars 101 and have each two support bars 10′ and 10″. Stages 100 are lowered and the inside ends of inner leads 31 are bent upwardly as shown in Fig. 6(i′) which is similar in this respect to Figs. 6(f′) and 6(h′).

7

Fig. 8 is a graph illustrating a relationship between a bending amount t and a width ratio $W_1$, $W_0$ between a connecting bar and a stage. These notations (t, $W_1$, $W_0$) are indicated in the illustrations inserted in Fig. 8. The shape of lead frame used for obtaining test data for the graph was of the type disclosed by Fig. 6(c). The reference character L denotes the side dimension of a square outline of the support plate, which was chosen to be a length of 24 mm. The dimension $W_0$ was chosen to be 3 mm. The bending amount t was measured when the assembly of circuit substrate and lead frame was heated up to 175°C, which is a package molding temperature. Fig. 8 shows that the smaller the width of connecting bar is, the less the bending amount is.

Fig. 9 is a diagram illustrating a relationship between a bending amount t and the shape of connecting bar. Similar tests were performed at 175°C using lead frames having support plate structures as shown in Fig. 6(c) and Figs. 6(f), 6(f'). The former group has a larger bending amount t than the latter group in which the support bar is (deliberately) bent and the stage is lowered.

Fig. 10 is a graph illustrating probability of package cracking versus number of heat cycles. The tests for obtaining the graph data were performed using test pieces having an area ratio Y of about 60% and a side dimension L of 23 mm in Fig. 8. In Fig. 10, the curve indicated by an encircled 1 is a reproduction of the curve for Y = 0% in Fig. 5; the curve indicated by encircled 2 illustrates crack probability data for the support plate structure of Fig. 6(c) where $W_1/W_0$ is 0.2; the curve indicated by encircled 3 shows data for Fig. 6(b); the curve indicated by encircled 4 shows data for Fig. 6(f) where $W_1/W_0$ is given as 0.2; and the curve indicated by encircled 5 shows data for both the structure of Fig. 6(a) and the structure modified from Fig. 6(b) in which a connecting bar has an undulation.

Fig. 10 shows that the crack occurrence probability (as against number of heat cycles) can be significantly reduced by providing the opening in the support plate, even when the hybrid integrated circuit has a high percentage occupancy (ratio of circuit substrate area to package size).

When the continuing trend towards higher integration densities, integrated circuits, for example hybrid integrated circuits, are required in which semiconductor active elements (and passive elements such as capacitors and resistors) are mounted on both surfaces of a base member 5 forming a circuit substrate 2.

Fig. 11(a) is a schematic cross-sectional view of an example of such a (hybrid) device.

Chip capacitors 7 are mounted on both sides of the base member 5 and a semiconductor chip 6 and a resistor 7' are mounted on the upper surface thereof. The assembled circuit substrate 5 is bonded on a stage 100 of a support plate and is molded in a package 4. The lead frame used is of a type similar to that shown in Figs. 6(f) and 6(f'), but the inner leads 31 are not bent upwardly.

Fig. 11(b) is a cross-sectional view of an embodiment of the present invention, having elements mounted on both surfaces of a base member, in this case a hybrid device. A lead frame such as is illustrated in Fig. 6(h) is used in this embodiment. In the Figure, two semiconductor integrated circuit chips 6 are mounted on a front surface of the circuit substrate 2, and passive chip elements 7 such as resistor, capacitor, etc., are soldered on both surfaces of the circuit substrate 2.

When both surfaces of the base member are utilised for chip (or other element), a lead frame having a support plate without an opening cannot be used. Thus, integrated circuits (e.g. hybrid circuits) according to embodiments of the present invention can have particular merits when both surfaces of a chip substrate are used for mounting chip parts or elements.

In order to fix a circuit substrate 2 on to a stage 100 of a lead frame, a bonding method using adhesive is generally employed. However, another method can be used in which the circuit substrate 2 is clipped or pinched by or between a pair of clippers or pincer portions of the stage. Fig. 12 is a schematic cross-sectional view of a device in which tip portions of a stage 85 are separated into upper and lower portions 85a and 85b. Portions 85a and 85b clip or pinch a fringe or edge of a circuit substrate 2.

As explained with reference to Figs. 8 and 9, an assembled lead frame and circuit substrate 2 warp downwardly when heated up to 170°C to 180°C during a molding process. The bending amount t is relieved by providing the opening in the support plate 8, but the bend or warp still remains after molding. This is illustrated in the cross-sectional view of Fig. 13, in which $x_1$ and $x_2$ denote thicknesses of upper and lower portions of a mold package 4 with regard to the base member 5, which forms the circuit substrate 2 with chip parts (not shown). In the Figures, $x_2$ represents a dimension (thickness) below the support plate 8, which is substantially equal to that below the base member 5. Generally, $x_1$ and $x_2$ are chosen to be almost equal, as shown in Fig. 13, and the packaged device shows, as a whole, a downward bend. States occurring during a transfer molding process are shown schematically and somewhat exaggeratedly in Figs. 14(a) and 14(b). In Fig. 14(a), the assembled parts are inserted in a molding cavity 20 and heated up to about 175°C, and the circuit substrate 2 and support plate 8 show a downward convex bend. After an injection of epoxy resin material, the mold package is cooled down to room temperature. In this process, the shrinkage forces in the upper and lower portions of the mold package with regard to the circuit substrate 2 are almost equal; therefore, the resin mold hardens without recovery from the bent shape.

Another embodiment of the present invention utilises a package structure as illustrated in Figs. 15(a) and 15(b) to solve the above problem.

Fig. 15(a) is a plan view of the embodiment, in which an upper portion of the mold material is partially removed, and Fig. 15(b) is a cross-sectional view thereof. The parts used therein are similar to those used in the previous embodiments. The device may be a hybrid or non-hybrid device, with elements mounted on one or both sides of a circuit substrate. In the illustrated embodiment, a circuit substrate 2 has a square size of 23 x 23 mm$^2$ and a 0.6 mm thickness.

To detect device deformation, thick film resistors of 10 kilo-ohms were formed on both surfaces of a base member 5 by a printing method (instead of forming the circuit substrate 2 with chip parts). A film resistor is a sensitive passive element which can be used easily to detect deformation of the substrate on which the resistor is formed.

Symbols $x_1$ and $x_2$ (see Fig. 16(b)) denote thickness of upper and lower portions of the mold package respectively. Several kinds of test pieces were fabricated to enable measurement of deformation, which depends on a relationship between $x_1$ and $x_2$, and the best conditions sought. The total thickness of $x_1$ and $x_2$ was changed over a range between 3 mm and 5 mm, and the ratio $x_1/x_2$ was changed over a range between 0.3 and 1.5. When the best condition is found, the device shapes in the molding process as shown in Figs. 16(a) and 16(b), which are illustrations of a kind similar to Figs. 14(a) and 14(b). When the assembled parts are heated up to about 175°C, a downward convex bend is seen in Fig. 16(a) as in Fig. 14(a). However, when the test piece has a ratio $x_1/x_2$ of the selectively predetermined value in fabrication, in this case $x_1 < x_2$, the packaged device recovers its original flat surface after being cooled down as shown in Fig. 16(b).

Test results for mold packages with film resistors are shown in the graphs of Figs. 17 and 18. The ordinates of the graphs in both Figures indicate resistance change in percent and the abscissae indicate the ratio $x_1/x_2$ of upper mold thickness to lower mold thickness. Fig. 17 shows data for resistors formed on the front surfaces of the base members 5 and Fig. 18 shows data for resistors formed on the bottom surfaces thereof.

Generally, resistance value of a film resistor increases when the base member 5 on which the film resistor is formed is subjected to an upward convex deformation and, on the other hand, resistance value decreases when the substrate is subjected to an upward concave deformation.

Test pieces were fabricated utilising alumina ceramic for the base member 5, having an expansion coefficient of about $7.2 \times 10^{-6}/°C$, and copper alloy for the support plate, having an expansion coefficient of about $16.9 \times 10^{-6}/°C$. The expansion of the former is much less than that of the latter, a little less than a half of the latter. As shown in Figs. 17 and 18, the resistance change is almost null (zero) when $x_1/x_2$ is about 0.7.

If a resistance change within 0.2% is allowable, the thickness ratio $x_1/x_2$ is preferably selected to be in a range between 0.6 and 0.8.

In the above example pieces, the expansion of the circuit substrate 2 (base member 5) is smaller than that of the support plate 8, and therefore the upper thickness $x_1$ of the mold package above the base member 5 is selected to be smaller than the lower thickness $x_2$ thereunder. On the other hand, when the expansion of the base member 5 is larger than that of the support plate 8, for example when an iron-nickel alloy such as the so-called "41 alloy" is used therefor, the circuit substrate and the support plate show upward convex deformation when heated up. Therefore, the upper thickness $x_1$ of the mold package above the circuit substrate is selected to be larger than the lower thickness $x_2$ under the circuit substrate.

The test pieces had thick film resistors on the base member, being elements which are susceptible to deformation. Other elements such as capacitors and semiconductor chips are also apt to change characteristics due to deformation. Therefore, in embodiments of the present invention having a package structure in which the thickness ratio $x_1/x_2$ is selectively chosen has features of less dispersion in characteristics and a high quality.

An integrated circuit, for example a hybrid integrated circuit, in accordance with an embodiment of the present invention includes a circuit substrate on which at least one of an active and passive elements are formed, a lead frame having a support plate which has an opening therein and supports the circuit substrate thereon, and a mold of resin for packaging the circuit substrate, support plate and inner leads of the lead frame. A bottom surface of the circuit substrate is exposed and made free to contact the mold resin through the opening. The support plate has four stages, at the corners of an imaginary square or rectangle shape, spaced apart and supporting the substrate. The bottom surface area of the circuit substrate is not larger than the imaginary square or rectangle shape. The hybrid integrated circuit has a ratio of exposed bottom surface to total bottom surface greater than 50%, and has a ratio of surface area of the circuit substrate to principal surface area of the mold greater than 60%. This structure relieves mechanical stress caused in the mold package and eliminates or reduces occurrences of crack defects in the mold.

Further, an integrated circuit package structure for avoiding or reducing deformation thereof is provided in accordance with the invention in which mold thicknesses above and below the circuit substrate are selectively chosen.

Further, an integrated circuit package structure is provided in accordance with the invention in which elements can be mounted on both main surfaces of a base member.

## Claims

1. An integrated circuit, comprising:-
   a circuit substrate (2), comprising a base member (5) and at least one semiconductor element (6, 7, 7'), an active element or a passive element, disposed on the base member (5),
   a lead frame (9) comprising at least a plurality of leads (3) and a support plate (8), respectively provided at outward and inward portions of the lead frame (9), and each lead (3) having an inner lead portion (31) and an outer lead portion (32),
   the circuit substrate (2) being disposed on the support plate (8) and selectively electrically connected with inner ends of inner lead portions (31),
   a mold (4) of resin material packaging the circuit substrate (2), support plate (8) and inner lead portions (31), the ratio of the surface area of the base member (5) to the principal surface area of the mold package being greater than 60%, and
   the support plate (8) having an opening (80) for exposing the bottom surface of the base member (5) to the mold (4), the ratio of the exposed bottom surface area to the entire bottom surface area thereof being greater than 50%,
   and wherein
   the support plate (8) comprises four stages (100; 85) arranged at respective corners of either an imaginary square shape or an imaginary rectangular shape, the stages (100; 85) being spaced apart and supporting the base member (5), and the bottom surface area of the base member (5) being not larger than that of the imaginary square or rectangular shape.

2. An integrated circuit as claimed in claim 1, wherein said ratio of the exposed bottom surface area to the entire bottom surface area is greater than 90%.

3. An integrated circuit as claimed in claim 1 or 2, wherein the base member (5) is of insulating material.

4. An integrated circuit as claimed in claim 3, wherein the insulating material is alumina ceramic, epoxy glass, glass coated metal, oxide covered silicon, or sapphire.

5. An integrated circuit as claimed in claim 1, 2, 3 or 4, wherein the lead frame (9) is of copper alloy or iron nickel alloy.

6. An integrated circuit as claimed in any preceding claim, wherein each stage (100; 85) is provided with a single support bar (10) connecting it to the remainder of the lead frame (9) and arranged in an outward diagonal direction.

7. An integrated circuit as claimed in any preceding claim, wherein each stage (100; 85) is provided with two support bars (10', 10") connecting it to the remainder of the lead frame (9), the directions of the support bars forming a right angle, each direction being parallel to a side of the square or rectangular shape.

8. An integrated circuit as claimed in any preceding claim, wherein each stage (100; 85) is provided with three support bars (10, 10', 10") connecting it to the remainder of the lead frame (9), the directions of two of those support bars forming a right angle, each direction being parallel to a side of the square or rectangular shape, and the remaining support bar being arranged in an outward diagonal direction.

9. An integrated circuit as claimed in any preceding claim, wherein the four stages (100; 85) are formed in two pairs, each of two adjacent stages (100; 85), the two stages (100; 85) of each pair being mutually connected by a connecting bar (101) therebetween, the connecting bar (101) having a width less than a side dimension of a stage (100; 85).

10. An integrated circuit as claimed in any of claims 1 to 8, wherein the support plate (8) further comprises four connecting bars (101), each connecting bar (101) connecting two adjacent stages (100; 85) with each other and having a width less than a side dimension of a stage (100; 85).

11. An integrated circuit as claimed in claim 6, 7 or 8, or claim 9 or 10 when read as appended to claim 6, 7 or 8, wherein each support bar (10, 10', 10'') is bent, resulting in a lowering of the level of the four stages (100; 85) from the principal level of the lead frame (9), whereby the level difference between the upper surface of the circuit substrate (2) and the inner lead portions (31) is reduced.

12. An integrated circuit as claimed in claim 11, wherein inner lead portions (31) are further bent upwardly to raise the inside ends thereof higher than the principal level, whereby said level difference is further reduced.

13. An integrated circuit as claimed in claim 11 or 12 when read as appended to claim 9 or 10, wherein the or each connecting bar (101) has two downwardly sloped portions and a horizontal portion therebetween.

14. An integrated circuit as claimed in claim 11 or 12 when read as appended to claim 9 or 10, or as claimed in claim 13, wherein each connecting bar (101) lies in the same plane as the stages and has an undulation.

15. An integrated circuit as claimed in any preceding claim, wherein each stage (85) is formed in a shape providing a pair of upper and lower clipper or pincer portions (85a, 85b), a fringe of the base member (5) being clipped or pinched therebetween.

16. An integrated circuit as claimed in any preceding claim, having semiconductor elements (6, 7, 7') on both upper and lower surfaces of the base member (5).

17. An integrated circuit as claimed in any preceding claim, being a hybrid integrated circuit with at least one active (6) and one passive element (7, 7').

18. An integrated circuit as claimed in any preceding claim, wherein
the mold (4) thickness above the base member (5) is smaller than that below the base member (5) when the thermal expansion coefficient of the circuit substrate (2) is smaller than that of the support plate (8), or
mold (4) thickness above the base member (5) is larger than that below the base member (5) when the thermal expansion coefficient of the circuit substrate (2) is larger than that of the support plate (8).

19. An integrated circuit as claimed in claim 18, wherein a mold (4) thickness above the base member (5) is smaller than that below the base member (5) when the base member (5) is of alumina ceramic and the support plate (8) is of copper alloy.

20. An integrated circuit as claimed in claim 18, wherein a mold (4) thickness above the base member (5) is larger than that below the base member (5) when the base member (5) is of alumina ceramic and the support plate (8) is of a nickel-iron alloy.

21. An integrated circuit as claimed in claim 20, wherein the nickel-iron alloy is 42 alloy.

22. An integrated circuit as claimed in any preceding claim, being a hybrid integrated circuit.


**Patentansprüche**

1. Integrierte Schaltung, die aufweist:-
ein Schaltungssubstrat (2), das ein Basisteil (5) und zumindest ein Halbleiterelement (6, 7, 7') aufweist, und ein aktives Element oder ein passives Element, das an dem Basisteil (5) angeordnet ist,
einen Anschlußrahmen (9), der zumindest eine Vielzahl von Anschlüssen (3) und eine Trägerplatte (8) aufweist, die an nach außen gerichteten bzw. nach innen gerichteten Abschnitten des Anschlußrahmens (9) vorgesehen sind, und wobei jeder Anschluß (3) einen inneren Anschlußabschnitt (31) und einen äußeren Anschlußabschnitt (32) hat,
wobei das Schaltungssubstrat (2) an der Trägerplatte (8) angeordnet ist und selektiv, elektrisch mit inneren Enden der inneren Anschlußabschnitte (31) verbunden ist,

11

eine Form (4) aus Harzmaterial, die das Schaltungssubstrat (2), die Trägerplatte (8) und die inneren Anschlußabschnitte (31) kapselt, wobei das Verhältnis des Oberflächengebiets des Basisteils (5) zu dem Haupt-Oberflächengebiet des Formgehäuses größer als 60% ist, und

wobei die Trägerplatte (8) eine Öffnung (80) zum Freilegen der Bodenoberfläche des Basisteils (5) gegenüber der Form (4) hat, und das Verhältnis des freiliegenden Bodenoberflächengebiets zu dem gesamten Bodenoberflächengebiet davon größer als 50% ist, und worin

die Trägerplatte (8) vier Stufen (100; 85) hat, die an jeweiligen Ecken von entweder einer imaginären, quadratischen Form oder einer imaginären, rechteckigen Form angeordnet sind, wobei die Stufen (100; 85) voneinander beabstandet sind und das Basisteil (5) tragen und wobei das Bodenoberflächengebiet des Basisteils (5) nicht größer ist als das der imaginären, quadratischen oder rechteckigen Form.

2. Integrierte Schaltung, wie in Anspruch 1 beansprucht, worin das Verhältnis des freigelegten Bodenoberflächengebiets zu dem gesamten Bodenoberflächengebiet größer als 90% ist.

3. Integrierte Schaltung, wie in Anspruch 1 oder 2 beansprucht, worin das Basisteil (5) aus einem isolierenden Material besteht.

4. Integrierte Schaltung, wie in Anspruch 3 beansprucht, worin das isolierende Material eine Aluminiumoxidkeramik, ein Epoxydglas, ein glasbeschichtetes Metall, ein oxidabgedecktes Silicium oder Saphir ist.

5. Integrierte Schaltung, wie in Anspruch 1, 2, 3 oder 4 beansprucht, worin der Anschlußrahmen (9) aus einer Kupfer-Legierung oder Eisen-Nickel-Legierung besteht.

6. Integrierte Schaltung, wie in einem vorhergehenden Anspruch beansprucht, worin jede Stufe (100; 85) mit einem einzelnen Trägerbalken (10) versehen ist, der sie mit dem Rest des Anschlußrahmens (9) verbindet und der in einer nach außen gerichteten Diagonalrichtung angeordnet ist.

7. Integrierte Schaltung, wie in einem vorhergehenden Anspruch beansprucht, worin jede Stufe (100; 85) mit zwei Trägerbalken (10′, 10″) versehen ist, die sie mit dem Rest des Anschlußrahmens (9) verbindet, wobei die Richtungen der Trägerbalken einen rechten Winkel bilden und wobei jede Richtung zu einer Seite der quadratischen oder rechteckigen Form parallel ist.

8. Integrierte Schaltung, wie in einem vorhergehenden Anspruch beansprucht, worin jede Stufe (100; 85) mit drei Trägerbalken (10, 10′, 10″) versehen ist, die sie mit dem Rest des Anschlußrahmens (9) verbinden, wobei die Richtungen von zweien dieser Trägerbalken einen rechten Winkel bilden und wobei jede Richtung parallel zu einer Seite der quadratischen oder rechteckigen Form ist und wobei der restliche Trägerbalken in einer nach außen gerichteten Diagonalrichtung angeordnet ist.

9. Integrierte Schaltung, wie in einem vorhergehenden Anspruch beansprucht, worin die vier Stufen (100; 85) in zwei Paaren ausgebildet sind, jedes aus zwei benachbarten Stufen (100; 85), wobei die zwei Stufen (100; 85) jedes Paares gegenseitig durch einen Verbindungsbalken (101) zwischen ihnen verbunden sind und wobei der Verbindungsbalken (101) eine Weite hat, die kleiner als eine Seitenabmessung einer Stufe (100; 85) ist.

10. Integrierte Schaltung, wie in einem der Ansprüche 1 bis 8 beansprucht, worin die Trägerplatte (8) weiterhin vier Verbindungsbalken (101) aufweist, wobei jeder Verbindungsbalken (101) zwei benachbarte Stufen (100; 85) miteinander verbindet und eine Weite kleiner als eine Seitenabmessung einer Stufe (100; 85) hat.

11. Integrierte Schaltung, wie in Anspruch 6, 7 oder 8, oder Anspruch 9 oder 10, wenn sie angehängt an den Anspruch 6, 7 oder 8 gelesen werden, worin jeder Trägerbalken (10, 10′, 10″) gebogen ist, was in einem Absenken des Niveaus der vier Stufen (100; 85) von dem Hauptniveau des Anschlußrahmens (9) resultiert, wodurch die Niveaudifferenz zwischen der oberen Oberfläche des Schaltungssubstrats (2) und den inneren Anschlußabschnitten (31) reduziert wird.

12. Integrierte Schaltung, wie in Anspruch 11 beansprucht, worin innere Anschlußabschnitte (31) weiterhin nach oben gebogen sind, um die innenseitigen Enden davon höher als das Hauptniveau anzuheben, wodurch die Niveaudifferenz weiter reduziert wird.

13. Integrierte Schaltung, wie in Anspruch 11 oder 12 beansprucht, wenn sie angehängt an die Ansprüche 9 oder 10 gelesen werden, worin der oder jeder Verbindungsbalken (101) zwei nach unten gerichtete, schräge Abschnitte und einen horizontalen Abschnitt dazwischen hat.

14. Integrierte Schaltung, wie in Anspruch 11 oder 12 beansprucht, wenn sie angehängt an den Anspruch 9 oder 10 gelesen werden, oder wie in Anspruch 13 beansprucht, worin jeder Verbindungsbalken (101) in der gleichen Ebene wie die Stufen liegt und eine Welle hat.

15. Integrierte Schaltung, wie in einem vorhergehenden Anspruch beansprucht, worin jede Stufe (85) in einer Form ausgebildet ist, die ein Paar von oberen und unteren Klemmoder Quetschabschnitten (85a, 85b) bereitstellt, wobei ein Rand des Basisteils (5) zwischen ihnen eingeklemmt oder eingequetscht ist.

16. Integrierte Schaltung, wie in einem vorhergehenden Anspruch beansprucht, die Halbleiterelemente (6, 7, 7') an beiden oberen und unteren Oberflächen des Basisteils (5) hat.

17. Integrierte Schaltung, wie in einem vorhergehenden Anspruch beansprucht, die eine hybride, integrierte Schaltung mit zumindest einem aktiven (6) und einem passiven Element (7, 7') ist.

18. Integrierte Schaltung, wie in einem vorhergehenden Anspruch beansprucht, worin

die Dicke der Form (4) oberhalb des Basisteils (5) kleiner als die unterhalb des Basisteils (5) ist, wenn der thermische Ausdehnungskoeffizient des Schaltungssubstrats (2) kleiner als der der Trägerplatte (8) ist, oder

worin die Dicke der Form (4) oberhalb des Basisteils (5) größer als die unterhalb des Basisteils (5) ist, wenn der thermische Ausdehnungskoeffizient des Schaltungssubstrats (2) größer als der der Trägerplatte (8) ist.

19. Integrierte Schaltung, wie in Anspruch 18 beansprucht, worin eine Dicke der Form (4) oberhalb des Basisteils (5) kleiner als die unterhalb des Basisteils (5) ist, wenn das Basisteil (5) aus Aluminiumoxidkeramik und die Trägerplatte (8) aus einer Kupfer-Legierung besteht.

20. Integrierte Schaltung, wie in Anspruch 18 beansprucht, worin eine Dicke der Form (4) oberhalb des Basisteils (5) größer als die unterhalb des Basisteils (5) ist, wenn das Basisteil (5) aus einer Aluminiumoxidkeramik und das Trägerteil (8) aus einer Nickel-Eisen-Legierung besteht.

21. Integrierte Schaltung, wie in Anspruch 20 beansprucht, worin die Nickel-Eisen-Legierung eine 42-Legierung ist.

22. Integrierte Schaltung, wie in einem vorhergehenden Anspruch beansprucht, die eine hybride, integrierte Schaltung ist.

**Revendications**

1. Circuit intégré, comprenant :

un substrat (2) de circuit comprenant un organe de base (5) et au moins un élément semi-conducteur (6, 7, 7'), un élément actif ou un élément passif disposé sur l'organe de base (5),

un cadre (9) à fils de connexion comprenant au moins plusieurs fils de connexion (3) et une plaque de support (8) placés respectivement aux parties externe et interne du cadre à fils de connexion (9), chaque fil de connexion (3) ayant une partie de fil interne (31) et une partie de fil externe (32),

le substrat (2) de circuit étant placé sur la plaque de support (8) et étant électriquement connecté de manière sélective aux extrémités internes des parties de fil internes (31),

un boîtier moulé (4) d'un matériau à base de résine logeant le substrat de circuit (2), la plaque de support (8) et les parties de fil internes (31), le rapport de la surface de l'organe de base (5) à une grande face du boîtier moulé étant supérieur à 60 %, et

la plaque de support (8) ayant une ouverture (80) d'exposition de la surface inférieure de l'organe de base (5) au moule (4), le rapport de la surface inférieure exposée à la totalité de la surface inférieure étant supérieur à 50 %, et

dans lequel la plaque de support (8) comporte quatre tablettes (100 ; 85) placées à des coins respectifs d'une forme carrée ou rectangulaire imaginaire, les tablettes (100 ; 85) étant espacées et supportant l'organe de base (5), la surface inférieure de l'organe de base (5) n'étant pas supérieure à la forme du carré ou du rectangle imaginaire.

2. Circuit intégré selon la revendication 1, dans lequel le rapport de la surface inférieure exposée à la totalité de la surface inférieure est supérieur à 90 %.

3. Circuit intégré selon la revendication 1 ou 2, dans lequel l'organe de base (5) est formé d'un matériau isolant.

4. Circuit intégré selon la revendication 3, dans lequel le matériau isolant est une céramique d'alumine, un verre époxyde, un métal revêtu de verre, du silicium revêtu d'un oxyde ou du saphir.

5. Circuit intégré selon la revendication 1, 2, 3 ou 4, dans lequel le cadre (9) à fils de connexion est formé d'un alliage de cuivre ou d'un alliage de fer-nickel.

6. Circuit intégré selon l'une quelconque des revendications précédentes, dans lequel chaque tablette (100 ; 85) a une seule barre de support (10) la raccordant au reste du cadre à fils de connexion (9) et placée en diagonale vers l'extérieur.

7. Circuit intégré selon l'une quelconque des revendications précédentes, dans lequel chaque tablette (100 ; 85) possède deux barres de support (10′, 10″) qui la raccordent au reste du cadre à fils de connexion (9), les directions des barres de support formant un angle droit, chaque direction étant parallèle à un côté de la configuration du carré ou du rectangle.

8. Circuit intégré selon l'une quelconque des revendications précédentes, dans lequel chaque tablette (100 ; 85) possède trois barres de support (10, 10′, 10″) qui la raccordent au reste du cadre à fils de connexion (9), les directions de deux des barres de support formant un angle droit, chaque direction étant parallèle à un côté de la forme du carré ou du rectangle, la barre restante de support étant disposée vers l'extérieur en diagonale.

9. Circuit intégré selon l'une quelconque des revendications précédentes, dans lequel les quatre tablettes (100 ; 85) sont formées par deux paires, comprenant chacune deux tablettes adjacentes (100 ; 85), les deux tablettes (100 ; 85) de chaque paire étant connectées mutuellement par une barre de connexion (101) placée entre elles, la barre de connexion (101) ayant une largeur inférieure à une dimension du côté d'une tablette (100 ; 85).

10. Circuit intégré selon l'une quelconque des revendications 1 à 8, dans lequel la plaque de support (8) comporte en outre quatre barres de connexion (101), chaque barre de connexion (101) raccordant deux tablette adjacentes (100 ; 85) l'une à l'autre et ayant une largeur inférieure à la dimension du côté d'une tablette (100 ; 85).

11. Circuit intégré selon la revendication 6, 7 ou 8 ou la revendication 9 ou 10 lorsqu'elle dépend de la revendication 6, 7 ou 8, dans lequel chaque barre de support (10, 10′, 10″) est cintrée et provoque un abaissement du niveau des quatre tablettes (100 ; 85) par rapport au niveau principal du cadre à fils de connexion (9), si bien que la différence de niveaux entre la surface supérieure du substrat du circuit (2) et les parties de fil internes de connexion (31) est réduite.

12. Circuit intégré selon la revendication 11, dans lequel les parties de fil internes (31) sont en outre cintrées vers le haut de manière que leurs extrémités internes soient soulevées au-dessus du niveau principal, si bien que la différence de niveau est encore plus réduite.

13. Circuit intégré selon la revendication 11 ou 12 lorsqu'elle dépend de la revendication 9 ou 10, dans lequel la barre ou chaque barre de connexion (101) a deux parties inclinées vers le bas et une partie horizontale entre elles.

14. Circuit intégré selon la revendication 11 ou 12 lorsqu'elle dépend de la revendication 9 ou 10 ou selon la revendication 13, dans lequel chaque barre de connexion (101) se trouve dans le même plan que les tablettes et a une ondulation ;

15. Circuit intégré selon l'une quelconque des revendications précédentes, dans lequel chaque tablette (85) a une configuration donnant une paire de parties supérieure et inférieure d'agrafes ou de pinces (85a, 85b) entre lesquelles est agrafé ou pincé un bord de l'organe de base (5).

16. Circuit intégré selon l'une quelconque des revendications précédentes, ayant des éléments semi-conducteur (6, 7, 7') aux faces supérieure et inférieure de l'organe de base (5).

17. Circuit intégré selon l'une quelconque des revendications précédentes, sous forme d'un circuit intégré hybride ayant au moins un élément actif (6) et un élément passif (7, 7').

18. Circuit intégré selon l'une quelconque des revendications précédentes, dans lequel :
l'épaisseur de la partie moulée (4) au-dessus de l'organe de base (5) est inférieure à l'épaisseur au-dessous de l'organe de base (5) lorsque le coefficient de dilatation thermique du substrat du circuit (2) est inférieur à celui de la plaque de support (8), ou
l'épaisseur de la partie moulée (4) au-dessus de l'organe de base (5) est supérieure à l'épaisseur au-dessous de l'organe de base (5) lorsque le coefficient de dilatation thermique du substrat du circuit (2) est supérieur à celui de la plaque de support (8).

19. Circuit intégré selon la revendication 18, dans lequel l'épaisseur de la partie moulée (4) au-dessus de l'organe de base (5) est inférieure à l'épaisseur au-dessous de l'organe de base (5) lorsque l'organe de base (5) est une céramique d'alumine et la plaque de support (8) est un alliage de cuivre.

20. Circuit d'intégration selon la revendication 18, dans lequel l'épaisseur de la partie moulée (4) au-dessus de l'organe de base (5) est supérieure à l'épaisseur au-dessous de l'organe de base (5) lorsque l'organe de base (5) est une céramique d'alumine et la plaque de support (8) est un alliage de fer-nickel.

21. Circuit intégré selon la revendication 20, dans lequel l'alliage de fer-nickel est l'alliage "42 alloy"

22. Circuit intégré selon l'une quelconque des revendications précédentes, sous forme d'un circuit intégré hybride.

FIG. 1(a)

FIG. 1(b)

FIG. 2

FIG. 3

FIG. 4(a)

Number of heat cycles until 10% occurrence of crack defect

$X = \dfrac{S_0}{S_1}$

$S_1 = 10 \times 10^{mm^2}$

$14 \times 14\, mm^2$

$20 \times 20\, mm^2$

$28 \times 28\, mm^2$

$40 \times 40\, mm^2$

Occupancy percentage X(%)

FIG. 4(b)

$S_0$: Surface area of circuit substrate

$S_1$: Principal surface area of mold package

FIG. 5

FIG. 6(a)

FIG. 6(b)

FIG. 6(c)

FIG.6(d)

FIG.6(e)

**FIG. 6 (f)**

**FIG. 6 (f')**

**FIG. 6 (g)**

**FIG. 6 (g')**

FIG. 6(h)

FIG. 6(h')

FIG. 6(i)

31

100

A — A'

10'

10''

10L

FIG. 6(i')

2

31

10'

101

## FIG. 7

## FIG. 8

FIG. 9

FIG. 10

FIG. 11(a)

FIG. 11(b)

FIG. 12

FIG. 13

FIG. 14(a)

FIG. 14(b)

FIG. 16(a)

FIG. 16(b)

175°C

$x_1$

$x_2$

FIG. 15(a)

80a

10

FIG. 15(b)

$x_1$

$x_2$

FIG. 17

FIG. 18